(19) Europäisches Patentamt
European Patent Office
Office européen des brevets

(11) **EP 2 112 517 A1**

(12) **EUROPEAN PATENT APPLICATION**
published in accordance with Art. 153(4) EPC

(43) Date of publication:
**28.10.2009 Bulletin 2009/44**

(51) Int Cl.:
*G01R 31/08* (2006.01)   *H02H 3/08* (2006.01)
*H02H 3/38* (2006.01)   *H02H 7/26* (2006.01)

(21) Application number: **08736679.5**

(22) Date of filing: **13.02.2008**

(86) International application number:
**PCT/ES2008/000075**

(87) International publication number:
**WO 2008/099037 (21.08.2008 Gazette 2008/34)**

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **14.02.2007 ES 200700392**

(71) Applicant: **Universidad Del Pais Vasco-Euskal Herriko Unibertsitatea**
**48940 Leioa (Bizkaia) (ES)**

(72) Inventors:
• **URIONDO ARRUE, Felipe**
 **E-48940 Leioa (Bizkaia) (ES)**
• **HERNÁNDEZ GONZÁLEZ, José Ramón**
 **E-48940 Leioa (Bizkaia) (ES)**

(74) Representative: **Urizar Barandiaran, Miguel Angel**
**Consultores Urizar y Cia, S.L.**
**Gordoniz 22 5°**
**48012 Bilbao (Bizkaia) (ES)**

(54) **ELECTRIC LINE PROTECTION FOR DETERMINING THE DIRECTION IN WHICH A FAULT OCCURS**

(57) The invention relates to electric line protection for determining the direction in which a fault occurs, which makes use of direct sequence power. For this purpose, a scalar value is calculated on the basis of the pr-fault voltage ($V_1^P$), the variation in voltage in respect of that prior to the fault ($\Delta V_1$), the variation in strength in respect of that prior to the fault ($\Delta I_{I1}$), the direct sequence impedance of the line ($Z_{L1}$), the maximum phase difference between normal voltages at both ends of the line ($\theta$) and the values adjusted by the user ($\gamma$, $\delta$), and said value is compared with two pre-set references ($K_F$, $K_R$), also set by the user, in order to determine the direction of the fault. The scalar value is calculated using expression (I). The decision rule for determining the direction of the fault is as follows: if $_K < K_F$ the fault is in the forward direction and if $_K > K_R$ the fault is in the backward direction.

**Fig. 2**

EP 2 112 517 A1

**Description**

**SECTOR OF THE TECHNIQUE**

| | |
|---|---|
| Area: | Electrical Engineering |
| Discipline: | Electric Power Systems Protection |
| Sector Activity: | Directional unit to be used in electric power systems protection units |

For a protection unit with the task of responding to short circuits which occur in a specific electric line it is essential to determine, when a short circuit occurs, if it has taken place in the direction of the line it is covering (fault in front) or in the opposite direction (fault in rear).

The unit responsible for determining the direction in which the fault has arisen is commonly designated directional unit and plays a primary role in the quality of the protection unit it is a part of.

**STATE OF THE ART**

Directional units base their operation on the decomposition of the voltages and intensities which appear in a short circuit in voltages and intensities of three sequence networks called direct, inverse and homopolar sequence, respectively.

Directional units are classified according to the sequences they use to determine the direction in which the fault has occurred; thus, there are directional units of homopolar sequence, inverse sequence directional units and direct sequence directional units.

Homopolar sequence units are used to determine the direction in which single-phase and two-phase faults to earth occur while the inverse sequence units are used for both single-phase and two-phase faults. Lastly, to determine the direction in which the three-phase faults occur, the direct sequence directional unit is used.

This unit is a direct sequence unit which improves the traditional direct sequence unit used to determine the direction in which three-phase faults occur, improving their behaviour with respect to three-phase faults and making it valid not only for three-phase faults, but for all types of faults.

The traditional technique used in the direct sequence directional is based on the calculation of the following expression:

$$\chi = -\mathrm{Re}\left\{V_1^P \cdot I_1^* \cdot 1\angle -\theta_{L1}\right\}$$

Where:

- $V_1^P$ is the direct sequence voltage where the unit is installed before the short circuit occurs..

- $I_1^*$ is the fault intensity of conjugated direct sequence where the unit is installed.

- $\theta_{L1}$ is the angle of the direct impedance of the line.

The decision rule to determine the direction of the fault is:

- If $\chi > 0$ the fault has occurred in the front direction.

- If $\chi < 0$ the fault has occurred in the rear direction.

The new unit which is presented is supported by an unprecedented technique of the authors of the invention which shows that the direct sequence may be broken down into four terms, two of which always have opposing directions - one of the terms goes from the fault to the unit and the other from the unit to the fault - and which, therefore, is much preferable to divide the direct sequence power and consider these two terms separately.

In addition to the new technique on the powers brought into play in the short circuit, the unit which is presented utilizes the new polarization by power whose originality and ownership appears in the patent application P200602716, likewise presented by the inventors. Lastly, this directional can be combined with the one shown in the aforementioned application P200602716 to bring about a new generalized directional which includes all types of faults with a single comparator utilizing the maximum information which could be obtained in a short circuit.

In subsequent sections it will be shown that the direct sequence directional which has been utilized has an important problem which the new directional which is presented does not have.

The most important documentation to know in detail the state of the art is as follows:

(1) U.S. Patent No. 5,808,845 - System for preventing sympathetic tripping in a Power System.

(2) EP 0 769 836 A2 - A Directional Element.

(3) U.S. Patent No. 5,349,490 - Negative sequence directional element for a relay useful in protecting power transmission lines.

(4) U.S. Patent No. 5,365,396 - Negative sequence directional element for a relay useful in protecting power transmission lines.

(5) CA 2 108 443 - Negative Sequence Directional Element For a Relay Useful In Protecting Power Transmission

(6) G.E. Alexander, Joe Mooney and William Tyska, Joe, "Advanced Application Guidelines for Ground Fault Protection", 28th Annual Western Protective Relay Conference, Spokane, WA, October 2002.

(7) Jeff Roberts, Demetrious Tziouvaras, Gabriel Benmouyal et al, "The effect of Multiprinciple Line Protection on Dependability and Security", Schweitzer Engineering Laboratories Technical Papers, Pullman, WA 2001.

(8) Bogdan Kasztenny, Dave Sharples, Bruce Campbell and Marzio Pozzuoli, "Fast Ground Directional Overcurrent Protection - Limitations and Solutions", 27th Annual Western Protective Relay Conference, Spokane, WA, October 2000.

(9) Elmo Price, "Sequence Coordination Study AN-55L-00", Substation Automation and Protection Division, ABB Application Note, March 2000.

(10) G. Benmouyal and J. Roberts, "Superimposed Quantities: Their True Nature and Their Application in Relays", 26th Annual Western Protective Relay Conference, Spokane, WA, October 1999.

(11) J.L. Blackburn, "Protective Relaying: Principles and Application", Second Edition, Marcel Dekker Inc. New York, 1998.

(12) Bill Fleming, "Negative Sequence Impedance Directional Element", Schweitzer Engineering Laboratories Technical Papers, Pullman, WA 1998.

(13) Joe Mooney and Jackie Peer, "Application Guidelines for Ground Fault Protection", 24th Annual Western Protective Relay Conference, Spokane, WA, October 1997.

(14) Jeff Roberts and Edmund O. Schweitzer III, "Limits to the Sensitivity of Ground Directional and Distance Protection", 1997 Spring Meeting of the Pennsylvania Electric Association Relay Committee, Allentown, Pennsylvania, May 1997.

(15) Armando Guzman, Jeff Roberts and Daquing Hou, "New Ground Directional Elements Operate Reliably For Changing System Conditions", 51st Annual Georgia Tech Protective Relaying Conference, Atlanta, Georgia, April 1997.

(16) P.M. Anderson, "Analysis of Faulted Power Systems", IEEE-Press - Power Engineering Series, 1995.

(17) P.G. McLaren, G.W. Swift et Al, "A New Directional Element for Numerical Distance Relays", IEEE-PES Summer Meeting, San Francisco, CA, July 28, 1994, Paper No. 94 SM 429-1 PWRD.

(18) Jeff Roberts and Armando Guzman, "Directional Element Design and Evaluation ", 21st Annual Western Protective Relay Conference, Spokane, WA, October 1994.

(19) Karl Zimmerman and Joe Mooney, "Comparing Ground Directional Element Performance Using Field Data", 20th Annual Western Protective Relay Conference, Spokane, WA, October 1993.

(20) G.E. Alexander and J.G. Andrichak, "Ground Distance Relaying: Problems and Principles", 19th Annual Western Protective Relay Conference, Spokane, WA, October 1991.

(21) IEEE Guide for Protective Relay Applications to Transmission Lines. IEEE standard, January 2000.

## DESCRIPTION OF THE INVENTION

### *Introduction*

The invention presented is a new direct sequence directional element which notably improves the response of the traditional direct sequence unit on breaking down the power into addends which are dealt with separately, extracting the maximum information possible from the direct sequence magnitudes.

### *Explanation of the invention*

The invention consists to be used in an Electrical Power System which, when a short circuit is produced, utilizes the direct sequence power which circulates through the point at which the unit is located and that consumed by the line to determine the direction in which the short circuit is found. In order to do this it calculates a scale value from the pre-fault voltage ($V_1^P$), the voltage variation with respect to the pre-fault ($\Delta V_1$), the variation of the intensity with respect to the pre-fault ($\Delta I_1$), the direct sequence impedance of the line ($Z_{L1}$), the maximum phase change between healthy voltages at both ends of the line ($\theta$) and the values adjusted by the user ($\gamma$, $\delta$) which is compared with two prefixed references ($K_F$, $K_R$), also fixed by the user, to determine the direction of the fault.
The scale value is calculated by the following expression:

$$\kappa = \mathrm{Re}\left\{ \frac{\gamma \cdot \Delta V_1 \cdot \Delta I_1^* - \delta \cdot V_1^P \cdot \Delta I_1^* \cdot e^{j \cdot \theta}}{\gamma \cdot Z_{L1} \cdot \left| \Delta I_1 \right|^2} \right\}$$

The decision rule to determine the direction of the fault is:

- If $\kappa < K_F$ the fault has arisen in the front direction.
- If $\kappa > K_R$ the fault has arisen in the rear direction.

This invention proposes an electric line protection to determine the direction in which a fault is produced, which is characterized because it consists of a directional unit which receives the magnitudes of the electric line of direct sequence voltage ($V_1$), direct sequence voltage existing before the fault is produced ($V_1^P$), direct sequence intensity ($I_1$), direct sequence intensity existing before the fault is produced ($I_1^P$), the directional unit consisting of:

a) a power calculator module which consists of means to

a$_1$) calculate the direct sequence power supplied by the source to the short circuit ($S_{F1}$) which circulates through the point at which the system is installed, in accordance with the expression:

$$S_{F1} = V_1^P \cdot \Delta I_1^*$$

$\Delta I_1^*$ being the conjugate of the increase of the direct sequence intensity ($\Delta I_1 = I_1 - I_1^P$);

a$_2$) calculating the direct sequence power consumed by the entire line ($S_{L1}$) due to the fault, in accordance with the following expression:

$$S_{L1} = Z_{L1} \cdot \left| \Delta I_1 \right|^2$$

$Z_{L1}$ being the impedance of the direct sequence electric line;

a$_3$) calculating the direct sequence power (S$_1$) which circulates at the point in which the system is installed, in accordance with the expression:

$$S_1 = \Delta V_1 \cdot \Delta I_1^*$$

$\Delta V_1^*$ being the conjugate of the increase of direct sequence voltage ($\Delta V_1 = V_1 - V_1^P$);

b) a decision module which consists of means to:

b$_1$) determine a polarization signal which responds to the expression:

$$S_{POLARIZACIÓN} = \gamma \cdot Z_{L1} \cdot \left| \Delta I_1 \right|^2 = \gamma \cdot S_{L1}$$

where $S_{L1}$ is the direct sequence power of the line and $\gamma$ is the percentage of that power which we wish to include in the unit.

b$_2$) determine an operational signal which responds to the expression:

$$S_{OP} = \gamma \cdot \Delta V_1 \cdot \Delta I_1^* - \delta \cdot V_1^P \cdot \Delta I_1^* \cdot e^{j\theta} - \kappa \cdot S_{POL} = S - \kappa \cdot S_{POL}$$

where $S_1 = \Delta V_1 \cdot \Delta I_1^*$ y $S_{F1} = V_1^P \cdot \Delta I_1^*$ are the direct sequence powers supplied and consumed by the short circuit respectively and K is the border value chosen by the user, K=KF being for front faults and K=KR the border value for rear faults;

b$_3$) determine the real part (Re) of the product of the operational signal by the conjugate of the polarization signal, in accordance with the expression:

$$Re\left( S_{OPERACION} \cdot S_{POLARIZACION}^* \right)$$

b$_4$) decide that the direction of the fault has occurred "in front" of the system when the real part (Re) is negative and "in rear" when the real part is positive, which is formally expressed:

$$Re\left( \left( \gamma \cdot S_1 - \delta \cdot S_{1F} - \kappa \cdot \left( \gamma \cdot S_{L1} \right) \right) \left( \gamma \cdot S_{L1} \right)^* \right) \begin{vmatrix} < 0 \rightarrow \text{Falta delante} \\ > 0 \rightarrow \text{Falta detrás} \end{vmatrix}$$

It is also characterized because deducing from $Re\left\{ S_{OP} \cdot S_{POL}^* \right\} \leq 0$ the expression

$$\kappa = \mathrm{Re}\left\{ \frac{\gamma \cdot \Delta V_1 \cdot \Delta I_1^* - \delta \cdot V_1^P \cdot \Delta I_1^* \cdot e^{j\theta}}{\gamma \cdot Z_{L1} \cdot \left| \Delta I_1 \right|^2} \right\}$$

And setting $\kappa$ as border value $K_F$ for faults in front and the border value $K_R$ for rear faults, the decision module has directional means to decide that if:

$\kappa \le K_F$ the fault has arisen in front direction

$\kappa \ge K_R$ the fault has arisen in rear direction

its corresponding output being activated.

It is also characterized because the system consists of counter circuits, one which counts the samples during which the "front" output is kept activated and another one which counts the samples during which the "rear" output is kept activated, the output of the counter circuits being activated when the number of samples accumulated is such that the time the response has been maintained is greater than that corresponding to a pre-determined timing (threshold value).

It is also characterized because it consists of a counter circuit which, for a pre-set time, blocks the activation of the output in "front" direction to not allow changes in flow due to actions of associated switches of the system to bring about faulty performance of the unit.

It is also characterized because it consists of a signal adaptation module which consists of:

a) a memory circuit which stores the voltage and intensity values present at the moment prior to the occurrence of the short circuit.

b) two subtractors which calculate the variation of voltage and intensity between the pre-fault and fault situation.

It is also characterized because the unit does not start up if the variation of direct sequence intensity does not exceed a threshold pre-set by the user.

This unit has the following improved characteristics as compared to the traditional direct sequence unit.

- None of the magnitudes which intervene in the expression include the charge intensity which introduces a bias or error in the measuring of directionality.

- Both the fault and pre-fault voltages and the intensities are utilized; thus, the information used is the maximum obtainable in a short circuit of the direct sequence.

- The signal level obtained is much greater than that of the traditional direct sequence directional unit.

- It can be used for all types of faults, both single-phase and two-phase (pure and earthed) as well as three-phase.

- It is compatible with the homopolar and inverse sequence elements; effects can be added to obtain a single generalized directional unit.

### Brief description of the contents of the Figures

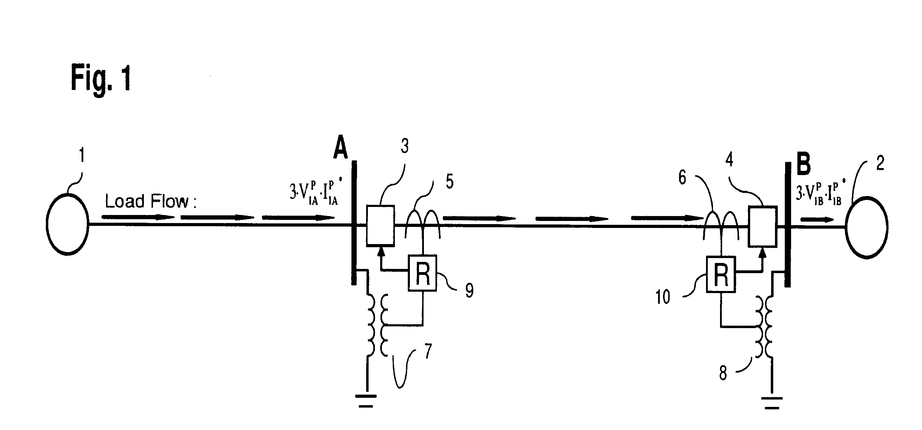

Shown in Figure 1 is an electric line of an electric power system. The electric line is located between the substations "A" and "B". Shown in this figure is the normal operating situation of the line, with charge circulating from one end to another. The direction of the power circulation from one end to the other is fixed by the ends of the arrows. In this example, we have assumed that the charge, as seen in the figure, circulates from "A" to "B".

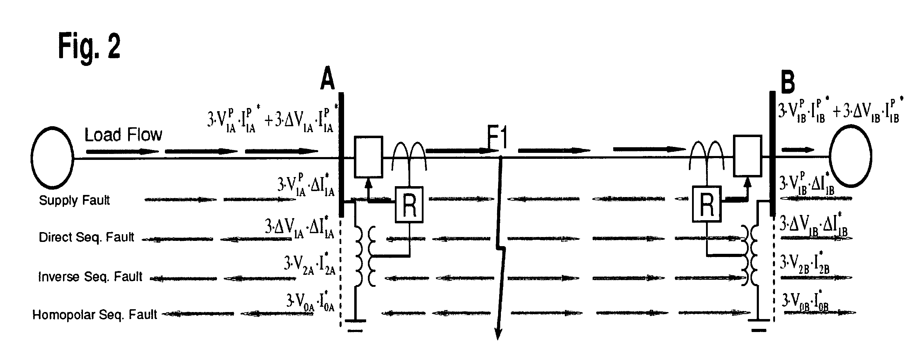

In Figure 2 the situation is presented which arises when the fault takes place in front of the protection. In the figure, it can be seen that the component $3 \cdot \Delta V_1 \cdot \Delta I_1^*$ circulates from the fault to the sources while the component

$3 \cdot V_1^P \cdot \Delta I_1^*$ circulates from the sources to the short circuit.

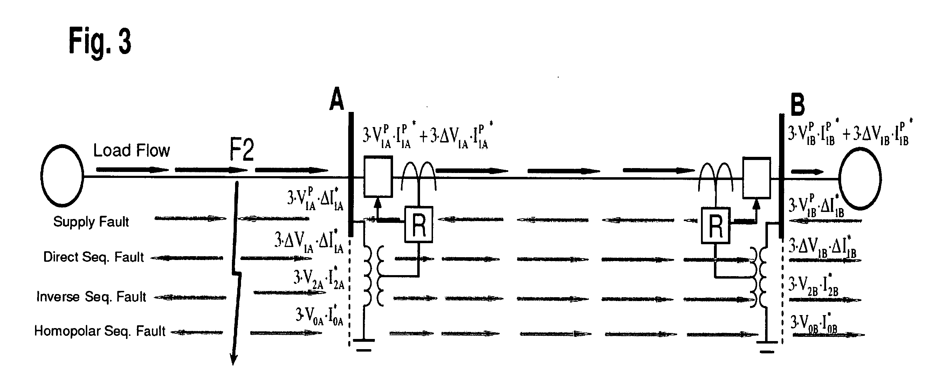

In Figure 3 the situation is presented which arises when the fault is behind the protection. In the figure, it can be seen that the direct sequence components continue flowing as in the previous case: $3 \cdot \Delta V_1 \cdot \Delta I_1^*$ flows from the short circuit to the sources while $3 \cdot V_1^P \cdot \Delta I_1^*$ flows from the sources to the short circuit. As the location of the fault with respect to the unit has changed, the two addends change direction when they are measured from the point where the unit is located.

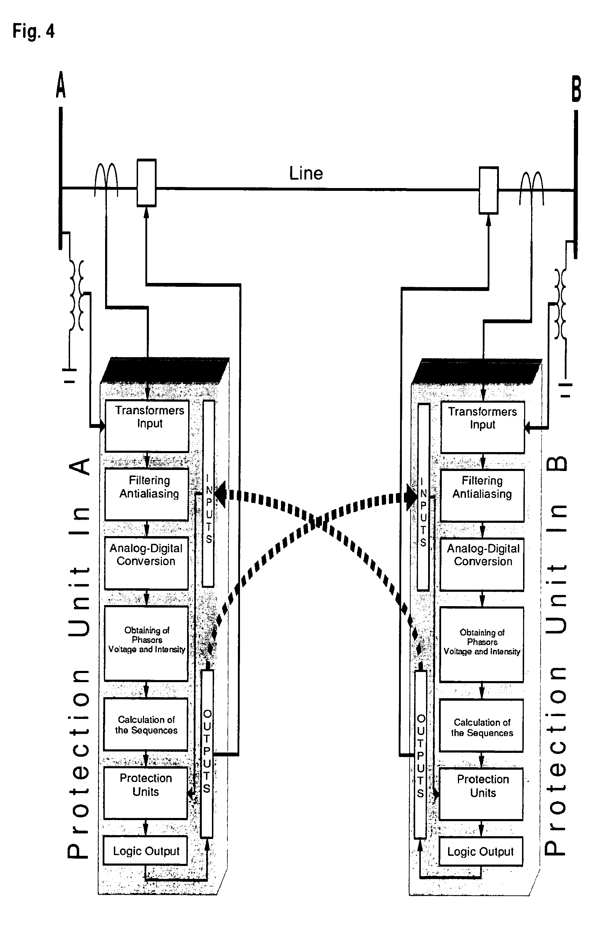

Shown in Figure 4 are the stages into which the performance of the protection unit are divided and the ratios with the measurement transformers and the switch in figures 1, 2 and 3.

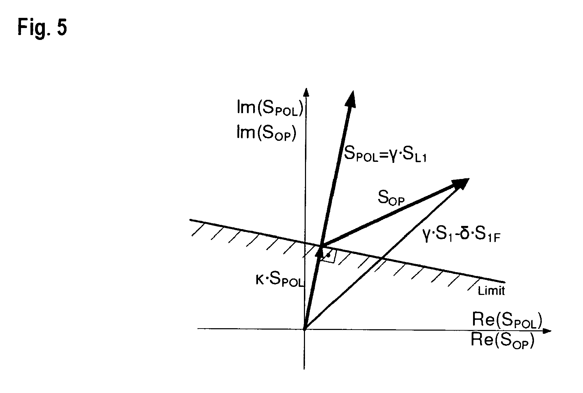

Shown in Figure 5 are the signals of polarization and operation of the direct sequence power-polarized comparator on which the operation of the unit is based when the fault occurs "behind" the protection:

$$Re(S_{OP}.S_{POL})^* > 0 \rightarrow \text{Fault in rear}$$

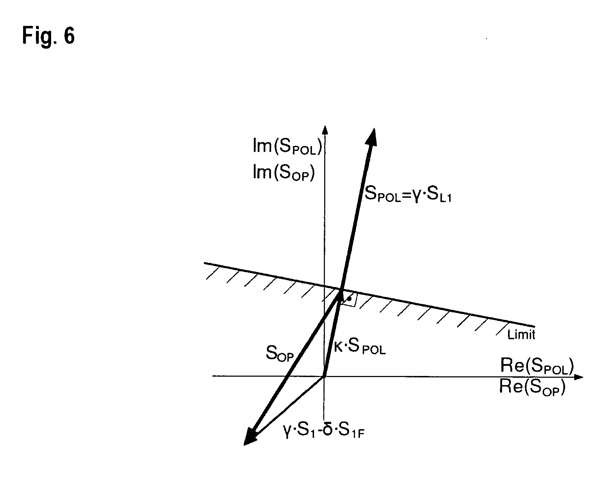

Shown in Figure 6 are the signals of polarization and operation of the direct sequence power-polarized comparator on which the operation of the unit is based when the fault occurs "in front of the protection:

$$Re(S_{OP}.S_{POL})^* < 0 \rightarrow \text{Fault in front}$$

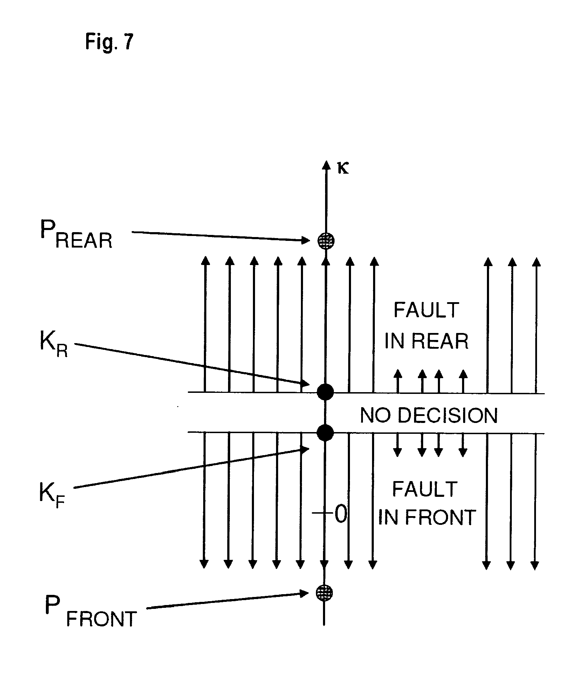

In Figure 7 three zones appear into which the response of the unit is divided according to the value of $\kappa$, $\kappa$ being the output of the direct sequence comparator:

$$\kappa = Re\left\{ \frac{\gamma \cdot \Delta V_1 \cdot \Delta I_1^* - \delta \cdot V_1^P \cdot \Delta I_1^* \cdot}{\gamma \cdot Z_{L1} \cdot |\Delta I_1|^2} \right\}$$

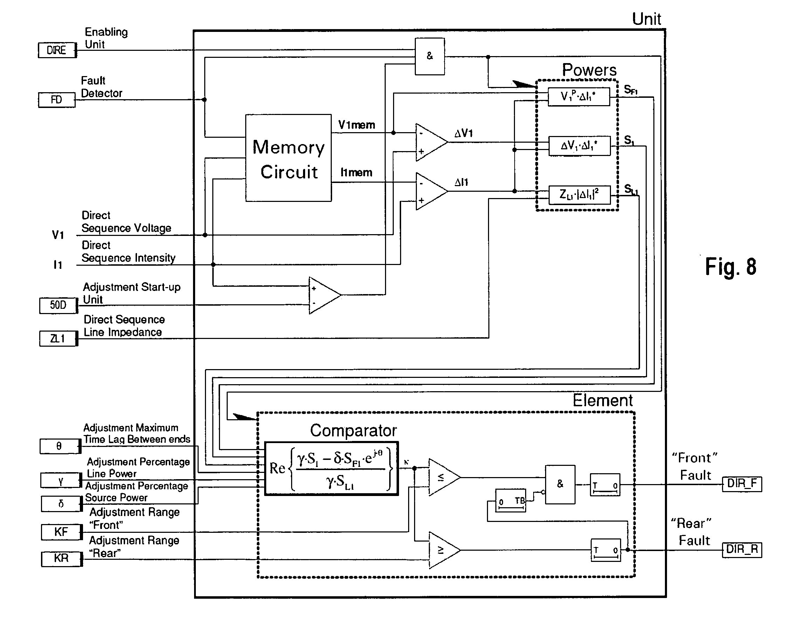

Shown in Figure 8 is the unit, that is, the implementation of the same. The memory circuit is included for clarity although it is an independent unit which is utilized in several applications. Likewise included is the circuit which confirms that the output is adequate through the check from which a certain number of samples are kept.

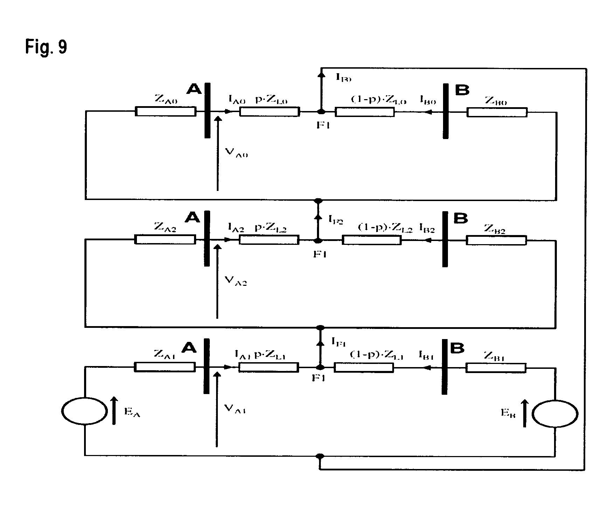

Shown in Figure 9 are the networks of direct, inverse and homopolar sequence connected in such a way that they reflect the existing ratios between voltages and intensities of the different sequences when a clear fault arises -that is, with nil fault resistance- in phase **R** to earth for a "front fault" of the protection at a specific distance "**p**" (in a ration of X:1) from substation A.

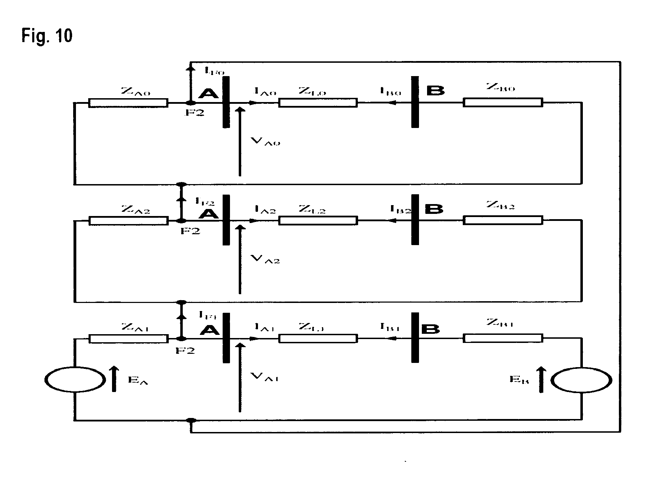

Shown in Figure 10 are the networks of diverse, inverse and homopolar sequence connected in such a way that they reflect the existing ratios between voltages and intensities of the different sequences when a clear fault arises -that is, with nil fault resistance- in phase R to earth for a fault at a point immediately previous to the location of the protection.

### *Detailed description of the invention*

In Figure 1 two line protections are shown (9) and (10) which, through intensity-measurement transformers (5) and (6) voltage measurement transformers (7) and (8), which reduce voltages and intensities to normalized low-voltage values, monitor the voltages and intensities of the line located between substations A and B.

In Figure 4 the way in which the protections of both ends are shown from the voltages and intensities reduced to normalized values by the measurement transformers. These voltages and intensities are analogically filtered, eliminating the high-frequency components. The voltages and intensities filtered are sampled and, from these values, the voltage and intensity phasors are obtained which are utilized by the different protection units which, through the appropriate logic, activate the protection outputs which open or close the line switches.

Returning to Figure 1, in normal operating conditions the switches which are found on both ends of line (3) and (4) are closed and the power transported by the line goes from one source (1) to the other (2) through it. The active and reactive power transported by the line can be calculated at each end by the expressions which appear in figure 1 corresponding to the normal situation.

When a short circuit occurs -Figures 2 and 3- the protections of both ends (9) and (10) detect it and order the switches to open (3) and(4) isolating the short circuit. In a normal network energy has alternative paths which allow the energy to continue flowing from A to B; thus, continuity of service is guaranteed.

En general, the apparent complex power which flows through a point of a three-phase line can be calculated from the voltages and intensities of the three phases (R, S and T) by the expression:

$$S_{TOTAL} = V_R \cdot I_R^{\bullet} + V_S \cdot I_S^{\bullet} + V_T \cdot I_T^{\bullet}$$

The new theory about the powers brought into play in a short circuit on a three-phase line show that when a short circuit occurs, the power can be expressed according to the voltages and intensities of three circuits called direct sequence network, inverse sequence network and homopolar sequence network by the expression:

$$S_{TOTAL} = 3 \cdot \left( V_1^P \cdot I_1^{P\bullet} + \Delta V_1 \cdot I_1^{P\bullet} + V_1^P \cdot \Delta I_1^{\bullet} + \Delta V_1 \cdot \Delta I_1^{\bullet} + V_2 \cdot I_2^{\bullet} + V_0 \cdot I_0^{\bullet} \right)$$

Where the meaning of the variables, all in reference to the point where the unit is located, is as follows:

- $V_1^P$: direct sequence voltage before the short circuit occurs.

- $I_1^{P\bullet}$ : Conjugate direct sequence intensity before the short circuit occurs.

- $\Delta V_1$ : variation of direct sequence voltage due to the short circuit.

- $\Delta I_1^{\bullet}$ : variation of the conjugate direct sequence intensity due to the short circuit.

- $V_2$ : inverse sequence voltage during the short circuit.

- $I_2^{\bullet}$ : conjugate inverse sequence intensity.

- $V_0$ : inverse sequence voltage during the short circuit.

- $I_0^{\bullet}$ : conjugate inverse sequence intensity

And the physical meaning of the terms, according to the new theory, is as follows:

- $V_1^P \cdot I_1^{P\bullet}$ : charge flow at the instant previous to the occurrence of the short circuit.

- $\Delta V_1 \cdot I_1^{P\bullet}$ : variation in charge flow due to the short circuit.

- $V_1^P \cdot \Delta I_1^{\bullet}$ : power supplied by the source to the short circuit.

- $\Delta V_1 \cdot \Delta I_1^{\bullet}$ : direct sequence power returned by the short circuit.

- $V_2 \cdot I_2^{\bullet}$ : inverse sequence power returned by the short circuit (S2).

- $V_0 \cdot I_0^*$ : homopolar sequence power returned by the short circuit (S0).

The application of these expressions at each end of the line in a fault situation brings about the situations described in Figure 2 for "Front Faults" and Figure 3 for "Rear Fault". If we compare both situations we see that for the protection located on end B no difference is appreciated as all the terms into which we can break down the power maintain their direction.

In this unit, only symmetric power has been utilized and not the terms of homopolar and inverse sequence power; therefore, the terms to take into account are as follows:

$$S_{\text{SIMÉTRICA}} = 3 \cdot \left( V_1^P \cdot I_1^{P*} + \Delta V_1 \cdot I_1^{P*} + V_1^P \cdot \Delta I_1^* + \Delta V_1 \cdot \Delta I_1^* \right)$$

The terms associated with the current which flows through the line before the short circuit occurs ($I_1^P$) depend on the charge flow existing at the instant in which the fault occurs and are in no way connected to the point where the short circuit occurs; thus, they cannot be utilized. Because of this we can only utilize:

$$S_{\text{SIMÉTRICA-FALTA}} = 3 \cdot \left( V_1^P \cdot \Delta I_1^* + \Delta V_1 \cdot \Delta I_1^* \right)$$

Analyzing 2 and 3 it can be observed that the first addend goes from the source to the short circuit and that the second one has exactly the opposite direction; that is, it goes from the short circuit to the source. Both terms are nil when the line is in normal operation; thus we can define a signal to determine the direction of the short circuit as follows:

$$S_{\text{DIRECCION}} = 3 \cdot \Delta V_1 \cdot \Delta I_1^* - 3 \cdot V_1^P \cdot \Delta I_1^* = 3 \cdot S_1 - 3 \cdot S_{F1}$$

Where the negative sign takes into account the fact that the two components have opposite directions.

Analyzing figures 2 and 3 it can be observed that the power returned by the short circuit which flows through the protection only runs through the line when the fault occurs "in the rear" of the unit, as when the fault occurs in front the power returned by the short circuit which flows through the unit is consumed by the source and not by the line. Taking this into account, we can take the power consumed by the line when the fault occurs in back as a reference to determine the direction in which the short circuit has occurred:

$$S_{\text{REFERENCIA}} = 3 \cdot Z_{L1} \cdot \left| \Delta I_1 \right|^2 = 3 \cdot S_{L1}$$

Heuristically we can say that the signals of reference and direction will coincide when the fault occurs in rear and will be opposite when the fault occurs in front. The application of this criterion materializes through a comparator whose polarization signal (reference) is:

$$S_{\text{POL}} = \gamma \cdot Z_{L1} \cdot \left| \Delta I_1 \right|^2 = \gamma \cdot S_{L1}$$

And whose operational signal (action) is:

$$S_{\text{OP}} = \gamma \cdot \Delta V_1 \cdot \Delta I_1^* - \delta \cdot V_1^P \cdot \Delta I_1^* \cdot e^{j\theta} - \kappa \cdot S_{\text{POL}} = S - \kappa \cdot S_{\text{POL}}$$

The values "γ" and "δ" represent the percentages of the power brought into play by the short circuit and by the source respectively which we wish to utilize in the comparator. The graphic representation of both signals is presented generically in Figure 5 for the two situations of interest. When the fault occurs "in rear" -Figure 5- both signals are approximately in phase and when the fault occurs "in front" -Figure 6- both are in counterphase. Due to this, the cosine of the angle formed by both signals will be positive when the fault occurs "in rear" and negative when the fault occurs "in front", as shown in Figures 5 and 6.

The criteria of action will be, therefore, that of a cosine comparator which responds to the following equation:

$$\text{Re}\left(S_{OP}\cdot S_{POL}^{*}\right)\begin{vmatrix} < 0 \rightarrow \text{Falta delante} \\ > 0 \rightarrow \text{Falta detrás}\end{vmatrix}$$

To determine the border for which the comparator stops giving positive output and begins to give negative output we must impose the condition that the output of the comparator is nil. At that point the following is fulfilled:

$$\text{Re}\left(S_{OP}\cdot S_{POL}^{*}\right) = 0 \rightarrow \text{Re}\left((S - \kappa\cdot S_{POL})\cdot S_{POL}^{*}\right) = \text{Re}\left(S\cdot S_{POL}^{*}\right) - \kappa\cdot\left|S_{POL}\right|^{2} = 0 \rightarrow \text{Re}\left(S\cdot S_{POL}^{*}\right) = \kappa\cdot\left|S_{POL}\right|^{2} \rightarrow$$

$$\rightarrow \text{Re}\left(\frac{S\cdot S_{POL}^{*}}{\left|S_{POL}\right|^{2}}\right) = \kappa \rightarrow \kappa = \text{Re}\left\{\frac{S}{S_{POL}}\right\} = \text{Re}\left\{\frac{\gamma\cdot\Delta V_{1}\cdot\Delta I_{1}^{*} - \delta\cdot V_{1}^{P}\cdot\Delta I_{1}^{*}\cdot e^{j\theta}}{\gamma\cdot Z_{L1}\cdot\left|\Delta I_{1}\right|^{2}}\right\}$$

The latter expression is much more adequate to be implemented numerically; thus the unit will calculate the expression:

$$\kappa = \text{Re}\left\{\frac{\gamma\cdot\Delta V_{1}\cdot\Delta I_{1}^{*} - \delta\cdot V_{1}^{P}\cdot\Delta I_{1}^{*}\cdot e^{j\theta}}{\gamma\cdot Z_{L1}\cdot\left|\Delta I_{1}\right|^{2}}\right\}$$

The meaning of the terms of the expression being those explained previously. The value calculated by the expression is compared with two limit values and as is shown in Figure 7, and the direction of the fault is determined with the following decision rule:

- $\kappa < K_F$: the fault has occurred "in front" direction.

- $\kappa > K_R$: the fault has occurred "in rear" direction.

- $K_F < \kappa < K_R$: the unit does not give output; it is the "no decision" zone.

The adjustment of the unit is made through the parameters $Z_{L1}$, γ, δ, θ, $K_F$ and $K_R$ in accordance with the following basic rules:

$Z_{L1}$: 100% of the direct sequence impedance of the line which is being protected by the unit must be introduced.

γ: can be adjusted between 1 and 100. It is a percentage. It represents the percentage of the direct sequence power returned by the fault which we wish to intervene in the unit.

δ: can be adjusted between 0 and 100. It is also a percentage. It represents the percentage of the power supplied by the source to the short circuit which we wish to intervene in the unit.

θ: is the maximum time lag that can exist between the voltages of the two ends of the line protected in normal operation. It corresponds to the existing time lag between the voltages of the two ends in a situation of maximum charge (adjust in degrees).

$K_F$ and $K_R$: can be adjusted between 0 and the 1, $K_R > K_F$ always being true. 0.5 is the half point; the closer to zero, the more probable it will be for the unit to give an output of blocking, or will indicate fault in rear, which is essentially the same. The closer to 1 it is, the more probable it will be to obtain an output in "front" direction. Likewise, the closer the two values are the smaller will be the zone of uncertainty and the more separated they are the probability that the unit will not give output will be greater.

## EXAMPLE OF REALIZATION OF THE INVENTION

To analyze the behaviour of the unit we start with a system such as that shown in Figure 1 -whose equivalent circuit for "front" faults is shown in Figure 9 and for "rear" faults in Figure 10- where it can be observed that the system considered is composed of a line with sources at both ends. The values, in secondary ohms, of the different elements which compose the system are as follows:

| Element | Sequence | | |
|---|---|---|---|
| | **Direct ($\Omega$secondary)** | **Inverse ($\Omega$secondary)** | **Homop. ($\Omega$secondary)** |
| **Line** | $Z_{L1} = 0'414 + 4,273j$ | $Z_{L2} = 0'414 + 4'273j$ | $Z_{L0} = 4'244 + 14'417j$ |
| **End A** | $Z_{A1} = 0'0414 + 0'4273j$ | $Z_{A2} = 0'0414 + 0'4273j$ | $Z_{A0} = 0'4244 + 1'4417j$ |
| **End B** | $Z_{B1} = 0'414 + 4,273j$ | $Z_{B2} = 0'414 + 4'273j$ | $Z_{B0} = 4'244 + 14'417j$ |

The value of the sources at both ends of the line is $E_A = 67'78V \angle 7'8°$ y $E_B = 70'85VL-5.4°$ respectively, measured in secondary volts. The calculated value of the pre-fault voltage at end A is $V_{AP} = 67'8V \angle 7'1°$ and the value of the pre-fault intensity at that end is $I_{AP} = 1'8AL 17'57°$.

Applying the criteria of adjustment shown in the foregoing section and knowing the data of the line and of the system we select the following values for the operation of the unit:

| Adjustment | Meaning | Value |
|---|---|---|
| 50D | Start-up of direct sequence directional unit | 0'5 |
| ZL1 | Direct sequence impedance of the protected line | 0'414+4'27 3j |
| $\gamma$ | Percentage of the direct sequence power returned for the desired fault | 1 |
| $\delta$ | Percentage of the direct sequence power supplied by the desired source | 1 |
| $\theta$ | Maximum time lag between voltages of the two ends of line in normal operation | 30° |
| KF | Range for "front" faults | 0'4 |
| KR | Range for "rear" faults | 0'6 |

We will now try to see the behaviour of the unit step by step in the two situations considered. We begin supposing that a clear single-phase fault occurs in phase R at 95% of the length of the line, measured from end A.

The voltages and intensities which appear at the point of the relay during this fault are as follows:

| $V_{A0}$ | $V_{A1}$ | $V_{A2}$ | $I_{A0}$ | $I_{A1}$ | $I_{A2}$ |
|---|---|---|---|---|---|
| $4'2V\angle 177'1°$ | $66'6V L 7'1°$ | $1'2V\angle -172°$ | $2'8A\angle -76'5°$ | $3'2A\angle -42'5°$ | $2'7A\angle -76'5°$ |

When the short circuit occurs the fault detector is activated and the input FD -which is the output of the fault detector unit - takes the logical true value (vide figure 8). Likewise, the unit is enabled; thus, the DIRE adjustment also has logical true value. Lastly, the current variation exceeds the threshold fixed by 50D as the direct sequence intensity variation is greater than 0'5A. AS the three inputs are active, the power calculation module and the element containing the comparator are enabled simultaneously. The memory circuit supplies the values of the voltage and the intensity before the short circuit occurs and the power calculation module calculates the following magnitudes from the fault and pre-fault values:

| Power | Meaning | Value |
|---|---|---|
| $S_{F1} = V_1^P \cdot \Delta I_1^*$ | Power supplied by the source to the short circuit | 189VA L 84˚ |
| $S_1 = \Delta V_1 \cdot \Delta I_1^*$ | Direct sequence power returned through the short circuit to the source | 3'3VA∟-96˚ |
| $S_{L1} = Z_{L1} \cdot |\Delta I_1|^2$ | Direct sequence power consumed by the line (reference) | 33'3VA∟84˚ |

Continuing with the diagram of Figure 8, the values calculated enter into the comparator and, with the adjustments selected calculate the expression:

$$\kappa = \text{Re}\left\{ \frac{\gamma \cdot \Delta V_1 \cdot \Delta I_1^* - \delta \cdot V_1^P \cdot \Delta I_1^* \cdot e^{j\cdot\theta}}{\gamma \cdot Z_{L1} \cdot |\Delta I_1|^2} \right\} = -5'048$$

As 5'042 is much less than KF - whose value is 0'4- after a pre-set number of samples se the DIR_F output is activated indicating that a fault has occurred "in front" of the protection. However, as -5'042 is not greater than KR - whose value is 0'6- the output which indicates that the fault has occurred in the rear is not activated.

The other case of interest is that occurring when the fault takes place "in the rear" of the protection. If the fault (clear single-phase fault in phase R) occurs at a point immediately "behind" the protection, the circuit to resolve will be the one presented in Figure 10.

The resolution of the circuit represented in Figure 10 leads to the following voltage and intensity values:

| $V_{A0}$ | $V_{A1}$ | $V_{A2}$ | $I_{A0}$ | $I_{A1}$ | $I_{A2}$ |
|---|---|---|---|---|---|
| 43'4V∟-177˚ | 55'6V∟5'6˚ | 12'4V∟-166˚ | 1'44A∟110˚ | 2'27A∟57'1˚ | 1'44A∟110˚ |

When the short circuit occurs in the line, the fault detector measures an increase of the homopolar and inverse intensities and activates their output. The output of the fault detector enters the unit (FD=true) and the unit being activated (DIRE=true) and exceeding the threshold 50D the power calculation module is activated as well as the element which contains the comparator.

The power calculation module calculates the following values:

| Power | Meaning | Value |
|---|---|---|
| $S_{F1} = V_1^P \cdot \Delta I_1^*$ | Power supplied by the source to the short circuit | 97'9VA∟- 102˚ |
| $S_1 = \Delta V_1 \cdot \Delta I_1^*$ | Direct sequence power returned through the short circuit to the source | 17'86VA∟84˚ |
| $S_{L1} = Z_{L1} \cdot |\Delta I_1|^2$ | Direct sequence power consumed by the line (reference) | 8'93VA L 84˚ |

These calculated values enter the comparator and the result of applying the expression is the one shown as follows:

$$\kappa = \mathrm{Re}\left\{\frac{\gamma \cdot \Delta V_1 \cdot \Delta I_1^* - \delta \cdot V_1^P \cdot \Delta I_1^* \cdot e^{j \cdot \theta}}{\gamma \cdot Z_{L1} \cdot |\Delta I_1|^2}\right\} = 12'079$$

As 12'1 is much greater than KR - whose value is 0'6- after the pre-set number of samples the output DIR_R is activated indicating that a fault "in rear" has occurred. However, as 12'1 is much greater than KF, this output is not activated.

**Claims**

1. Electric line protection for determining the direction in which a fault occurs, **characterized** because it consists of a directional unit which receives the magnitudes of an electric line of direct sequence voltage ($V_1$), direct sequence voltage existing before the occurrence of the fault ($V_1^P$), direct sequence intensity ($I_1$), direct sequence intensity existing before the occurrence of the fault ($I_1^P$), the directional unit consisting of:

   a) a power calculation module which consists of means to

   $a_1$) calculate the direct sequence power supplied through the source to the short circuit ($S_{F1}$) which flows through the point at which the system is installed, in accordance with the expression:

   $$S_{F1} = V_1^P \cdot \Delta I_1^*$$

   $\Delta I_1^*$ being the conjugate of the increase of direct sequence intensity ($\Delta I_1 = I_1 - I_1^P$);
   $a_2$) calculating the direct sequence power consumed by the entire line ($S_{L1}$) due to the fault, in accordance with the following expression:

   $$S_{L1} = Z_{L1} \cdot |\Delta I_1|^2$$

   $Z_{L1}$ being the impedance of the direct sequence electric line;
   $a_3$) calculating the direct sequence power ($S_1$) which circulates through the point at which the system is installed, in accordance with the expression:

   $$S_1 = \Delta V_1 \cdot \Delta I_1^*$$

   $\Delta V_1^*$ being the conjugate of the increase of the direct sequence voltage ($\Delta V_1 = V_1 - V_1^P$);

   b) a decision module which consists of means to:

   $b_1$) determine a polarization signal which responds to the expression:

   $$S_{\text{POLARIZACIÓN}} = \gamma \cdot Z_{L1} \cdot |\Delta I_1|^2 = \gamma \cdot S_{L1}$$

   where $S_{L1}$ is the direct sequence power of the line and $\gamma$ is the percentage of that power which we wish to include in the unit.
   $b_2$) determine an operational signal which responds to the expression:

$$S_{OP} = \gamma \cdot \Delta V_1 \cdot \Delta I_1^* - \delta \cdot V_1^P \cdot \Delta I_1^* \cdot e^{j\theta} - \kappa \cdot S_{POL} = S - \kappa \cdot S_{POL}$$

where $S_1 = \Delta V_1 \cdot \Delta I_1^*$ and $S_{F1} = V_1^P \cdot \Delta I_1^*$ are the direct sequence powers supplied and consumed by the short circuit respectively and K is the border value chosen by the user, K=KF being for front faults and K=KR the border value for rear faults;

b$_3$) determine the real part (Re) of the product of the operational signal by the conjugate of the polarization signal, in accordance with the expression:

$$Re\left(S_{OPERACION} \cdot S_{POLARIZACION}^*\right)$$

b$_4$) deciding that the direction of the fault has occurred "in front" of the system when the real part (Re) is negative and "in rear" when the real part is positive, which is formally expressed as follows:

$$Re\left(\left(\gamma \cdot S_1 - \delta \cdot S_{1F} - \kappa \cdot \left(\gamma \cdot S_{L1}\right)\right)\left(\gamma \cdot S_{L1}\right)^*\right) \begin{cases} < 0 \rightarrow \text{Falta delante} \\ > 0 \rightarrow \text{Falta detrás} \end{cases}$$

2. Electric line protection for determining the direction in which a fault occurs, according to foregoing claim, **characterized** because deduced from $Re\left\{S_{OP} \cdot S_{POL}^*\right\} \leq 0$ the expression

$$\kappa = Re\left\{\frac{\gamma \cdot \Delta V_1 \cdot \Delta I_1^* - \delta \cdot V_1^P \cdot \Delta I_1^* \cdot e^{j \cdot \theta}}{\gamma \cdot Z_{L1} \cdot \left|\Delta I_1\right|^2}\right\}$$

and the $\kappa$ fixed as border value $K_F$ for front faults and the border value $K_R$ for rear faults, the decision module has directional means to decide that if:

$\kappa \leq K_F$ the fault has occurred in the front direction
$\kappa \geq K_R$ the fault has occurred in the rear direction

the corresponding output being activated.

3. Electric line protection for determining the direction in which a fault occurs, according to foregoing claims, **characterized** because the system consists of counter circuits, one which counts the samples during which the output "to the front" is maintained activated and another which counts the samples during which the output "to the rear" is kept activated, the output of the counter circuits being activated when the number of samples accumulated is such that the time during which the response has been maintained is greater than the one corresponding to a pre-determined timing (threshold value).

4. Electric line protection for determining the direction in which a fault occurs, according to claim 3, **characterized** because it consists of a counter circuit which, for a pre-set time, blocks the activation of the output in "front" direction to not allow changes in flow due to actions of associated switches of the system bring about incorrect actions by the unit.

5. Electric line protection for determining the direction in which a fault occurs, according to claim 1, **characterized** because it consists of a module of signal adaptation which consists of:

a) a memory circuit which stores the values of voltage and intensity present at the moment prior to the occurrence of the short circuit.

b) two subtractors which calculate the variation of voltage and intensity between the pre-fault and fault situation.

**6.** Electric line protection for determining the direction in which a fault occurs, according to claim 1, **characterized** because the start-up of the unit does not occur if the variation of direct sequence intensity does not exceed a threshold pre-set by the user.

**Fig. 1**

Load Flow :

$3 \cdot V_{1A}^P \cdot I_{1A}^{P^*}$

$3 \cdot V_{1B}^P \cdot I_{1B}^{P^*}$

A

B

1

2

3

4

5

6

7

8

9

10

R

R

Fig. 2

**Fig. 2**

A          B

Load Flow

$3 \cdot V_{1A}^{P} \cdot I_{1A}^{P \; *} + 3 \cdot \Delta V_{1A} \cdot I_{1A}^{P \; *}$

$3 \cdot V_{1B}^{P} \cdot I_{1B}^{P \; *} + 3 \cdot \Delta V_{1B} \cdot I_{1B}^{P \; *}$

F1

Supply Fault    $3 \cdot V_{1A}^{P} \cdot \Delta I_{1A}^{*}$     R    R    $3 \cdot V_{1B}^{P} \cdot \Delta I_{1B}^{*}$

Direct Seq. Fault    $3 \cdot \Delta V_{1A} \cdot \Delta I_{1A}^{*}$     $3 \cdot \Delta V_{1B} \cdot \Delta I_{1B}^{*}$

Inverse Seq. Fault    $3 \cdot V_{2A} \cdot I_{2A}^{*}$     $3 \cdot V_{2B} \cdot I_{2B}^{*}$

Homopolar Seq. Fault    $3 \cdot V_{0A} \cdot I_{0A}^{*}$     $3 \cdot V_{0B} \cdot I_{0B}^{*}$

EP 2 112 517 A1

# Fig. 3

**A**

**B**

Load Flow

F2

$3 \cdot V_{1A}^{P} \cdot I_{1A}^{P*} + 3 \cdot \Delta V_{1A} \cdot I_{1A}^{P*}$

$3 \cdot V_{1B}^{P} \cdot I_{1B}^{P*} + 3 \cdot \Delta V_{1B} \cdot I_{1B}^{P*}$

$3 \cdot V_{1A}^{P} \cdot \Delta I_{1A}^{*}$

$3 \cdot V_{1B}^{P} \cdot \Delta I_{1B}^{*}$

Supply Fault

$3 \cdot \Delta V_{1A} \cdot \Delta I_{1A}^{*}$

$3 \cdot \Delta V_{1B} \cdot \Delta I_{1B}^{*}$

Direct Seq. Fault

$3 \cdot V_{2A} \cdot I_{2A}^{*}$

$3 \cdot V_{2B} \cdot I_{2B}^{*}$

Inverse Seq. Fault

$3 \cdot V_{0A} \cdot I_{0A}^{*}$

$3 \cdot V_{0B} \cdot I_{0B}^{*}$

Homopolar Seq. Fault

R

R

EP 2 112 517 A1

EP 2 112 517 A1

Fig. 4

19

Fig. 5

**Fig. 6**

Fig. 7

$P_{REAR}$

$K_R$

$K_F$

$P_{FRONT}$

κ

FAULT
IN REAR

NO DECISION

0

FAULT
IN FRONT

Fig. 8

EP 2 112 517 A1

**Fig. 9**

24

**Fig. 10**

# INTERNATIONAL SEARCH REPORT

| | International application No. |
|---|---|
| | PCT/ ES 2008/000075 |

**A. CLASSIFICATION OF SUBJECT MATTER**

see extra sheet

According to International Patent Classification (IPC) or to both national classification and IPC

**B. FIELDS SEARCHED**

Minimum documentation searched (classification system followed by classification symbols)
G01R, H02H

Documentation searched other than minimum documentation to the extent that such documents are included in the fields searched

Electronic data base consulted during the international search (name of data base and, where practicable, search terms used)

CIBEPAT,EPODOC

**C. DOCUMENTS CONSIDERED TO BE RELEVANT**

| Category* | Citation of document, with indication, where appropriate, of the relevant passages | Relevant to claim No. |
|---|---|---|
| A | EP 0769836 A2 (Schweitzer Eng. Lab) 23.04.1997 <br> the whole document | 1-6 |
| A | US 5349490 A (Roberts et al.) 20.09.1994 <br> column 2, line 50- column 5, line 20 | 1-6 |
| A | US 6584417 B1 (Hu et al.) 24.06.2003 <br> column 3, line 5- line 26 | 1-6 |
| A | AGRASAR, M, URIONDO, F., HERNANDEZ, J.R. "A useful methodology for analyzing distance relays performance during simple and inter-ciructi faults in multi-circuit lines" IEEE Transactions on Power delivery, vol 12, Issue 4 Oct 1997, ISSN 0885-8977 pages 1465-1471 | 1-6 |

☐ Further documents are listed in the continuation of Box C.    ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance. | |
| "E" earlier document but published on or after the international filing date | |
| "L" document which may throw doubts on priority claim(s) or which is cited to establish the publication date of another citation or other special reason (as specified) | "X" document of particular relevance; the claimed invention cannot be considered novel or cannot be considered to involve an inventive step when the document is taken alone |
| "O" document referring to an oral disclosure use, exhibition, or other means | "Y" document of particular relevance; the claimed invention cannot be considered to involve an inventive step when the document is combined with one or more other documents , such combination being obvious to a person skilled in the art |
| "P" document published prior to the international filing date but later than the priority date claimed | |
| | "&" document member of the same patent family |

| Date of the actual completion of the international search | Date of mailing of the international search report |
|---|---|
| 18.July.2008          (18.07.2008) | (22/07/2008) |
| Name and mailing address of the ISA/ <br> O.E.P.M. <br><br> Paseo de la Castellana, 75 28071 Madrid, España. <br> Facsimile No.   34 91 3495304 | Authorized officer <br><br> L. García Aparicio <br><br> Telephone No. +34 91 349 30 57 |

Form PCT/ISA/210 (second sheet) (April 2007)

## INTERNATIONAL SEARCH REPORT

Information on patent family members

International application No.

PCT/ ES 2008/000075

| Patent document cited in the search report | Publication date | Patent family member(s) | Publication date |
|---|---|---|---|
| EP 0769836 AB | 23.04.1997 | EP 19960307413 | 11.10.1996 |
| | | CN 1154586 A | 16.07.1997 |
| | | CN 1068145 C | 04.07.2001 |
| | | US 5694281 A | 02.12.1997 |
| | | EP 0932235 AB | 28.07.1999 |
| | | EP 19990302513 | 11.10.1996 |
| | | CN 1332506 A | 23.01.2002 |
| | | CN 1331290 C | 08.08.2007 |
| | | AT 223626 T | 15.09.2002 |
| | | AT 223117 T | 15.09.2002 |
| | | DK 769836 T | 07.10.2002 |
| | | DK 932235 T | 07.10.2002 |
| | | PT 932235 T | 29.11.2002 |
| | | PT 769836 T | 31.12.2002 |
| | | ES 2182458 T | 01.03.2003 |
| | | ES 2182954 T | 16.03.2003 |
| | | DE 69623350 T | 10.04.2003 |
| | | DE 69623406 T | 22.05.2003 |
| US 5349490 A | 20.09.1994 | CA 2108443 AC | 16.04.1994 |
| | | US 5365396 A | 15.11.1994 |
| US 6584417 B | 24.06.2003 | NONE | ------------ |

Form PCT/ISA/210 (patent family annex) (April 2007)

**INTERNATIONAL SEARCH REPORT**

| International application No. |
| --- |
| PCT/ ES 2008/000075 |

CLASSIFICATION OF SUBJECT MATTER

*G01R 31/08* (2006.01)
*H02H 3/08* (2006.01)
*H02H 3/38* (2006.01)
*H02H 7/26* (2006.01)

Form PCT/ISA/210 (extra sheeet) (April 2007)

**EP 2 112 517 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5808845 A
- EP 0769836 A2
- US 5349490 A
- US 5365396 A
- CA 2108443

**Non-patent literature cited in the description**

- **G.E. Alexander ; Joe Mooney ; William Tyska ; Joe.** Advanced Application Guidelines for Ground Fault Protection. *28th Annual Western Protective Relay Conference,* October 2002
- **Jeff Roberts ; Demetrious Tziouvaras ; Gabriel Benmouyal et al.** The effect of Multiprinciple Line Protection on Dependability and Security. *Schweitzer Engineering Laboratories Technical Papers,* 2001
- **Bogdan Kasztenny ; Dave Sharples ; Bruce Campbell ; Marzio Pozzuoli.** Fast Ground Directional Overcurrent Protection - Limitations and Solutions. *27th Annual Western Protective Relay Conference,* October 2000
- **Elmo Price.** Sequence Coordination Study AN-55L-00. *Substation Automation and Protection Division, ABB Application Note,* March 2000
- **G. Benmouyal ; J. Roberts.** Superimposed Quantities: Their True Nature and Their Application in Relays. *26th Annual Western Protective Relay Conference,* October 1999
- **J.L. Blackburn.** Protective Relaying: Principles and Application. Marcel Dekker Inc, 1998
- **Bill Fleming.** Negative Sequence Impedance Directional Element. *Schweitzer Engineering Laboratories Technical Papers,* 1998
- **Joe Mooney ; Jackie Peer.** Application Guidelines for Ground Fault Protection. *24th Annual Western Protective Relay Conference,* October 1997
- **Jeff Roberts ; Edmund O. Schweitzer III.** Limits to the Sensitivity of Ground Directional and Distance Protection. *1997 Spring Meeting of the Pennsylvania Electric Association Relay Committee,* May 1997
- **Armando Guzman ; Jeff Roberts ; Daquing Hou.** New Ground Directional Elements Operate Reliably For Changing System Conditions. *51st Annual Georgia Tech Protective Relaying Conference,* April 1997
- **P.M. Anderson.** Analysis of Faulted Power Systems. *IEEE-Press - Power Engineering Series,* 1995
- **P.G. McLaren ; G.W. Swift et al.** A New Directional Element for Numerical Distance Relays. *IEEE-PES Summer Meeting,* 28 July 1994
- **Jeff Roberts ; Armando Guzman.** Directional Element Design and Evaluation. *21st Annual Western Protective Relay Conference,* October 1994
- **Karl Zimmerman ; Joe Mooney.** Comparing Ground Directional Element Performance Using Field Data. *20th Annual Western Protective Relay Conference,* October 1993
- **G.E. Alexander ; J.G. Andrichak.** Ground Distance Relaying: Problems and Principles. *19th Annual Western Protective Relay Conference,* October 1991
- *IEEE Guide for Protective Relay Applications to Transmission Lines. IEEE standard,* January 2000

29